# EUROPEAN PATENT APPLICATION

(11) **EP 1 783 832 A1**
(43) Date of publication of application: **09.05.2007**
(21) Application number: 05765494.9
(22) Date of filing: 05.07.2005
(51) Int. Cl.: H01L 23/32

(54) **INTERPOSER AND INTERPOSER PRODUCING METHOD**

(30) Priority: 06.07.2004 JP 2004199785; 06.07.2004 JP 2004199870
(71) Applicant: Tokyo Electron Ltd., Tokyo 107-8481 (JP)
(72) Inventor: KAGAWA, K., Rowaru Shinmaruko 703, Kawasaki City, Kanagawa 211-0006 (JP); HOSHINO, Tomohisa, TOKYO ELECTRON AT LIMITED, saki City, Hyogo 660-0891 (JP); YAKABE, Masami, TOKYO ELECTRON AT LIMITED, Amagasaki City, Hyogo 660-0891 (JP)
(74) Representative: Liesegang, Eva
(86) International application number: PCT/JP2005/012424
(87) International publication number: WO 2006/004127

(57) **Abstract**

In a manufacturing method for an interposer, a seed layer is formed at an opening portion in a through hole on back surface side of a substrate, an electrode layer for electroplated coating is formed based on the seed layer, and an electroplated coating layer is formed to fill the through hole from the electrode layer for electroplated coating layer to a front surface side. As a result, a manufacturing method for an interposer is provided in which the manufacturing process is simple and the void is not generated inside of the through hole.

## Description

### TECHNICAL FIELD

The present invention relates to an interposer and a manufacturing method for the same, and more particularly, relates to an interposer and a manufacturing method for the same in which a pinch-off is not generated in a through hole.

### BACKGROUND ART

An interposer in which a conducting hole is prepared on a substrate in the prior art technology, is disclosed, for example, in Japanese Unexamined Patent Publication 2004-165291.

According to the above described Unexamined Patent Publication, a structure is disclosed wherein a conducting member is formed such that a diameter of the conducting member becomes larger or smaller in succession or in incremental steps from one side to another side in the ceramic substrate which has laminated greensheets of a plurality of through holes arranged in a predetermined pattern and filled with the conducting member, and a plurality of another through holes arranged in the same pattern having different diameters.

Fig. 9 is a cross sectional view to show a silicon substrate 80 explaining a problem in the prior art technology when an interposer is manufactured by arranging a conducting hole on the silicon substrate 80. Referring to Fig. 9, in the prior art technology, firstly a through hole 91 is formed on the silicon substrate 80. At this point, the through hole 91 becomes a cylindrical shape whose center portion is concave as shown in Fig. 9 rather than straight.

For the through hole 91, seed layers 83, 84 are formed by sputtering around the through hole 91 from both of a front surface 81 and a back surface 82. Then, conducting layers 85, 86 are formed by electroplated coating and the like utilizing the seed layers 83, 84 as a seed.

The interposer in the prior art technology is constituted as described above. According to the Unexamined Japanese Patent Publication 2004-165291, because the ceramic substrate is utilized and drilling or sand blasting is employed to open holes on the substrate, there is a problem that a diameter of the through hole cannot be made small. Moreover, because it is necessary to agglutinate two ceramic substrates, there is a problem that a manufacturing process becomes complicated.

Further, when the through hole is formed on the silicon substrate, because the center portion of the through hole has the concave shape and diameter of the through hole becomes larger as it goes inside from the front surface or the back surface, the seed layer cannot be formed well inside even when the seed layer is intended to be formed inside of the through hole. As a result, even when the conducting layer is grown from the seed layer by the electroplated coating and the like, because the conducting layer is not grown enough, so called "void" 92 is formed inside of the through hole 91, in which the conducting layer does not exist. This causes a problem that the through hole 91 is not conductive and the manufacturing precision is poor.

### DISCLOSURE OF THE INVENTION

The present invention is made to solve the above described problems and it is an object of the present invention to provide an interposer and manufacturing method for the same in which the manufacturing process is simple and the void is not generated inside of the through hole.

In accordance with one aspect of the present invention an interposer includes: a substrate which has one surface and another surface opposed to the one surface; a through hole being formed from the one surface to the another surface; a seed layer which is formed at an opening portion of the through hole on the one surface side of the substrate; an electrode layer for electroplated coating which is formed by covering the seed layer; and an electroplated coating layer which extends from the electrode layer for electroplated coating to the another surface side to fill the through hole.

Because the interposer according to the present invention includes the seed layer which is formed at the opening portion of the through hole on the one surface side of the substrate, the electrode layer for electroplated coating which is formed by covering the seed layer, and the electroplated coating layer which extends from the electrode layer for electroplated coating to the another surface side to fill the through hole, the electroplated coating layer can be surely formed from the seed layer on the one surface side of the substrate to the another surface side.

As a result, an interposer can be provided in which the manufacturing process is simple and the void is not generated inside of the through hole.

The through hole may have a shape whose center portion is concave. Further, the seed layer, the electrode layer for electroplated coating and the electroplated coating layer may be made out of the same material, or may be different materials.

In accordance with another aspect of the present invention, a manufacturing method for interposer includes steps of: preparing a substrate which has one surface and another surface; forming a through hole on the substrate; forming a seed layer at an opening portion of the through hole on the one surface side; and filling the through hole by forming an electroplated coating layer from the seed layer on the one surface side to the another surface side.

The manufacturing method for the interposer according to the present invention includes steps of forming a seed layer at an opening portion of the through hole on the one surface side and filling the through hole by forming an electroplated coating layer from the seed layer on the one surface side to the another surface side. Because the conducting layer is surely formed by the electroplating from the one surface side of the through hole on the substrate to another surface side, the void is not generated inside of the through hole.

As a result, a method for manufacturing the interposer can be provided that is simple and the void is not generated inside of the through hole.

Preferably, the step of filling the through hole by forming an electroplated coating layer from the seed layer on the one surface side to the another surface side includes steps of forming an electrode layer for electroplated coating to close the through hole at the one surface side, and forming the electroplated coating layer utilizing the electrode layer.

More preferably, the step of forming the through hole includes a step of forming a through hole whose center portion becomes concave.

At this point, the seed layer, the electrode layer for electroplated coating and the electroplated coating layer may be made out of the same material, or different materials.

In accordance with still another aspect of the present invention, an interposer includes a through hole which is made from a surface of one side of the substrate to a surface of another side, the through hole has a first opening area at the surface of the one side, and has a second opening area at the surface of the another side, and both of the first opening area and the second opening area become smaller in succession as they go from the surfaces to inside, and the interposer also includes a conducting layer which is formed in the through hole.

Because the interposer has the through hole whose opening area becomes smaller in succession as they go from the surfaces to inside, the through hole can be easily filled by the conducting layer.

As a result of this, an interposer whose manufacturing process is simple and the void is not generated inside of the through hole, can be provided.

Preferably, areas of the first opening and the second opening are different.

Because the values of the opening area on one surface side and another surface side are different, the wiring rules for the both surfaces can be independently settled, and wider degree of freedom for designing a wiring width and a wiring layout can be obtained.

More preferably, the through hole has a cylindrical portion between the surface of the one side and the surface of another side of the substrate.

In accordance with still another aspect of the present invention, an interposer has a through hole, in which the through hole is made from a surface of one side of the substrate to a surface of another side; the through hole has a first opening area at the surface of the one side, and the first opening area becomes smaller in succession as the hole goes from the surface of the one side to the surface of the another side; and a conducting layer is formed in the through hole.

In accordance with still another aspect of the present invention, a manufacturing method for the interposer including steps of: preparing a substrate which has one surface and another surface opposed to the one surface; forming a through hole by performing an etching such that an opening area of the through hole becomes smaller in succession as the hole goes from the surface of the one side and from the surface of the another side to inside; and forming a conducting layer in the through hole.

Because in this manufacturing method for interposer the through hole is formed by performing an etching such that an opening area of the through hole becomes smaller in succession as it goes from the surface of the one side and from the surface of the another side to inside, the conducting layer can be formed without any discontinuity inside of the through hole when the conducting layer is formed in the through hole.

As a result, a manufacturing method for the interposer which is simple and the void is not generated inside of the through hole, can be provided.

Preferably, the etching is performed such that the area of the opening of the surface on the one side and the area of the opening of the surface on another side are different.

More preferably, the manufacturing method further includes a step of forming a through hole whose opening area is constant from the surface of the one side to the surface of another side.

In accordance with still another aspect of the present invention, a manufacturing method for interposer including steps of: preparing a substrate which has one surface and another surface opposed to the one surface; forming a through hole by performing an etching such that an opening area of the through hole becomes smaller in succession as the hole goes from the surface of the one side to the surface of the another side; and forming a conducting layer in the through hole.

At this point, it is preferable that the etching is performed utilizing dry etching. The conducting layer may be formed utilizing evaporation, electroplated coating or electroless plating.

### BRIEF DESCRIPTION OF DRAWINGS

Fig. 1A is a diagram showing a manufacturing process of an interposer according to the first embodiment of the present invention step by step;
Fig. 1B is a diagram showing a manufacturing process of the interposer according to the first embodiment of the present invention step by step;
Fig. 1C is a diagram showing a manufacturing process of the interposer according to the first embodiment of the present invention step by step;
Fig. 1D is a diagram showing a manufacturing process of the interposer according to the first embodiment of the present invention step by step;
Fig. 2 is a diagram showing a manufacturing process of an interposer according to the second embodiment of the present invention;
Fig. 3A is a diagram to show a shape of a through hole to which the third embodiment of the present invention is applied;
Fig. 3B is a diagram showing a shape of the through hole to which the third embodiment of the present invention is applied;
Fig. 4A is a diagram showing a manufacturing process of an interposer according to the forth embodiment of the present invention step by step;
Fig. 4B is a diagram showing a manufacturing process of the interposer according to the fourth embodiment of the present invention step by step;
Fig. 4C is a diagram showing a manufacturing process of the interposer according to the forth embodiment of the present invention step by step;
Fig. 4D is a diagram showing a manufacturing process of the interposer according to the forth embodiment of the present invention step by step;
Fig. 5 is a cross sectional view showing a through hole on a substrate of an interposer according to the fifth embodiment of the present invention;
Fig. 6 is a cross sectional view showing a through hole on a substrate of an interposer according to the sixth embodiment of the present invention;
Fig. 7 is a perspective view showing a substrate of the interposer which has the cross sectional structure shown in Fig. 6;
Fig. 8A is a cross sectional view showing a through hole of an interposer according to the seventh embodiment of the present invention;
Fig. 8B is a diagram showing a manufacturing process of the through hole for the interposer according to the seventh embodiment of the present invention; and
Fig. 9 is a diagram to explain a problem of an interposer in the prior art technology.

### BEST MODE FOR CARRYING OUT THE INVENTION

### (1) First Embodiment

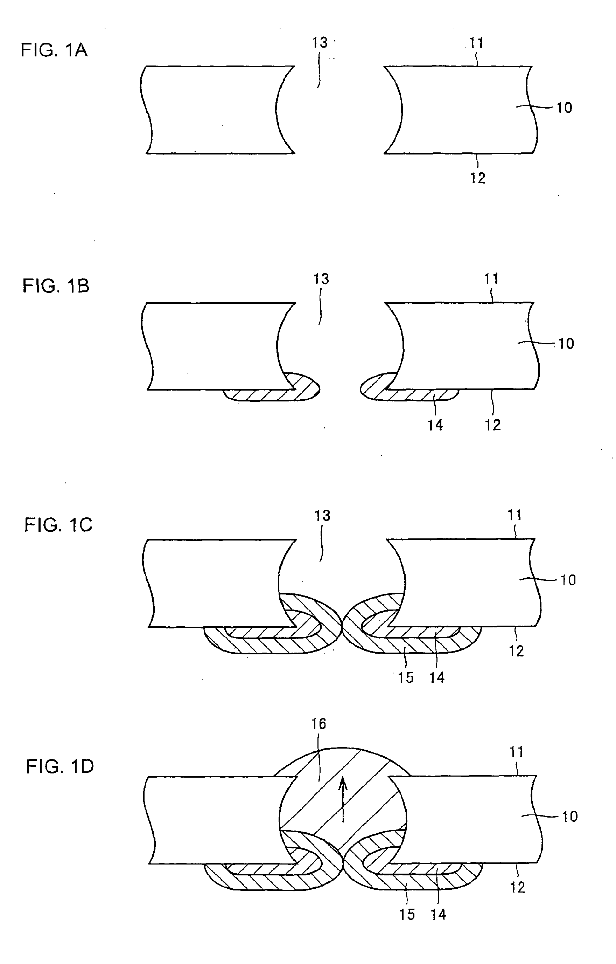

Hereinafter, the first embodiment according to the present invention will be described with reference to the accompanying drawings. Fig. 1A - Fig. 1D are diagrams to show step by step a manufacturing process of an interposer according to the first embodiment of the present invention. Referring to Fig. 1A - Fig. 1D, firstly a silicon substrate 10 having a front surface 11 and a back surface 12 is prepared, and a through hole 13 is opened on the substrate (Fig. 1A). At this point, the through hole 13 may be formed having a shape whose center portion is concave as shown in Fig. 1A as the interposer in the prior art. In this state, then, an insulating film which is not shown in the drawing, is formed on the substrate 10 including inside of the through hole 13. This insulating film may be made of SiO2, SiN and the like and is formed by sputtering, CVD or oxidization.

Next, Ti layer (not shown) as a barrier layer is formed by sputtering and the like around the through hole 13 where the insulating layer is formed on the back surface 12 of the substrate 10. Then, a seed layer 14 (a base layer for an electrode to flow current for electroplating) made out of Cu is formed on the barrier layer by sputtering and the like (Fig. 1B). An electroplated coating is performed from the back surface 12 based on the Cu seed layer 14. This electroplated coating is performed till an edge surface of the electroplating meets to close the through hole 13 at the back surface 12 so as to form an electrode layer for the electroplated coating of the electroplated coating layer 15 made out of Cu (Fig. 1C).

Next, an electroplated coating of Cu is performed to the front surface 11 utilizing the electroplated coating layer 15 of Cu as an electrode. By these steps, an electroplated coating layer of Cu grows in a direction shown by an arrow in Fig. 1D, and an electroplated coating layer 16 is prepared (Fig. 1D).

As described above, according to this embodiment, the through hole 13 can be made as the conducting layer of Cu without generating the void inside of the through hole even when the concave shaped hole is formed inside of the through hole 13.

At this point in the embodiment described above, though Ti is utilized as the barrier layer, this layer can be omitted.

### (2) Second Embodiment

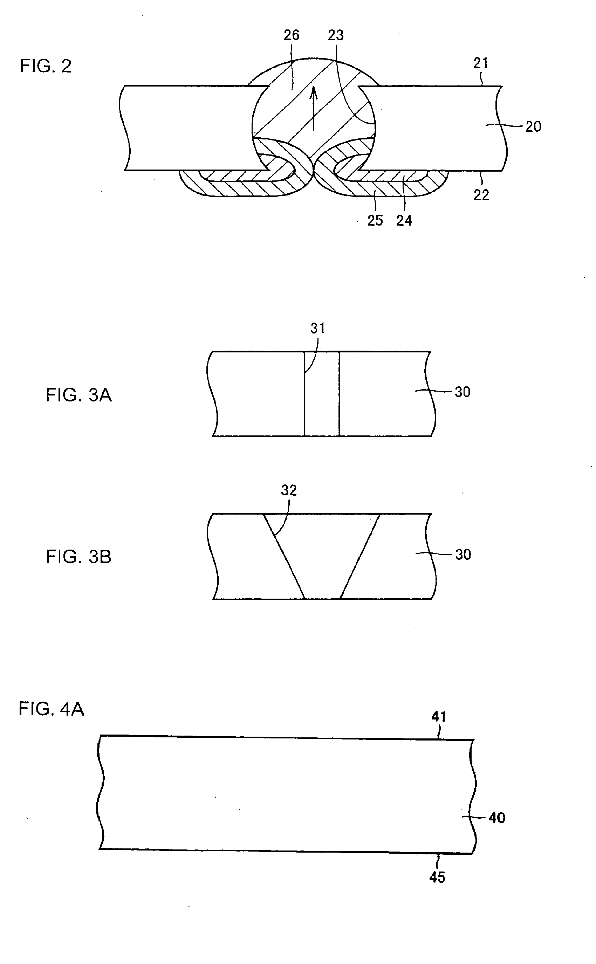

Next, an explanation will be given on the second embodiment. Fig. 2 is a diagram to show a manufacturing process of an interposer according to the second embodiment corresponding to Fig. 1D of the first embodiment, and the interposer has basically the same structure as shown in Fig. 1. Referring to Fig. 2, in this second embodiment, a through hole 23 is formed on a silicon substrate 20, and the through hole 23 is filled with a seed layer 24, an electrode layer 25 for electroplated coating and electroplated coating layer 26.

Though in the first embodiment, the seed layer and the electroplated coating layer made out of Cu are formed on the silicon substrate, in this embodiment the seed layer 24, the electrode layer 25 for electroplating and the electroplated coating layer 26 are made out of not only Cu but any material such as Ni, Cr, Au, Ag and the like as far as the electroplated coating can be performed. The material for the seed layer 24, the electrode layer 25 for electroplated coating and the electroplated coating layer 26 may be different from one another. For example, the seed layer may be made out of Cu and the electroplating of Au may be performed utilizing the seed layer as the electrode layer for electroplated coating.

### (3) Third Embodiment

Next, an explanation will be given on the third embodiment of the present invention. Fig. 3 is a diagram to show a shape of the through hole to which an interposer according to the third embodiment of the present invention is applied. Though in the first and the second embodiments, the present invention is applied to the through holes having the shape whose center portion becomes concave, the present invention can be applied to the substrate 30 with the through hole 31 having a cylindrical shape (Fig. 3A) and the through hole 32 having a diameter which becomes smaller in succession as the hole goes from the front surface to the back surface (Fig. 3B).

Though in the above described embodiments, the explanation is made on the embodiments utilizing the silicon substrate as a material for the substrate, these embodiments should not be considered as the restricted examples, and the present invention is applicable to the insulating substrate made out of such as glass and sapphire. In these cases, forming of the insulating layer described above is not necessary.

Though in the embodiments described above, the explanation is made on the cases in which filling of the conducting material into the through hole is performed by electroplated coating, the present invention should not be restricted to these examples, the filling may be performed by electroless plated coating.

### (4) Fourth Embodiment

Next, an explanation will be given on the fourth embodiment of the present invention. Fig. 4A - Fig. 4D are diagrams to show step by step a manufacturing process of an interposer according to the fourth embodiment of the present invention. Referring to Fig. 4A - Fig. 4D, in this embodiment firstly, a silicon substrate 40 having a front surface 41 and a back surface 45 is prepared (Fig. 4A). Then, a front surface hole 42 is formed which has a diameter that becomes smaller in succession as it goes into inside at a predetermined position on the front surface 41 of the substrate 40 by dry etching from the front surface 41. To be more specific, the etching is performed with appropriate combination of etching conditions of the isotropic etching and the anisotropic etching.

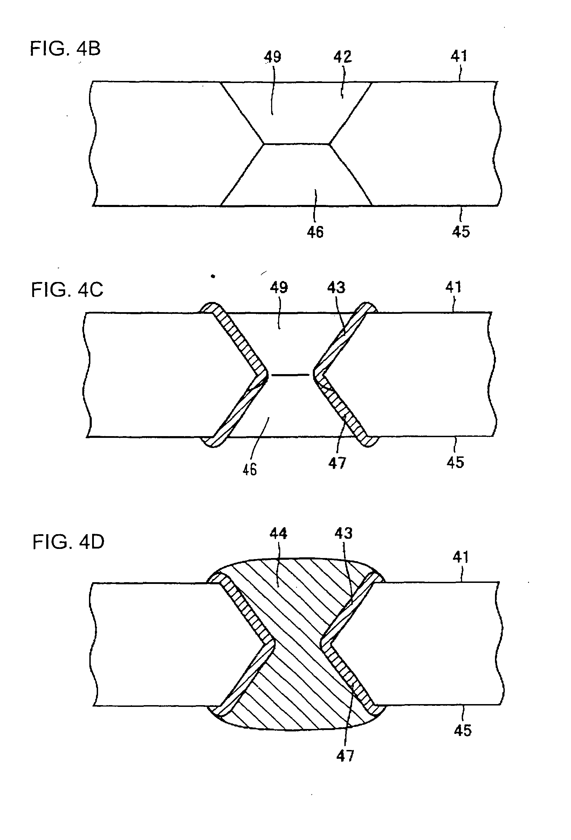

Next, a back surface hole 46 is formed which has diameter that becomes smaller in succession as it goes into inside on the back surface 45 of the substrate 40 by the same manner from the back surface 45, and center axis of the both holes are made substantially into a line at the center portion of the substrate 40. As described above, a through hole 49 is formed having a diameter that becomes smaller in succession as it goes into inside from the front surface 41 and the back surface 45 on the substrate 40 (Fig. 4B).

In this state, then, an insulating film which is not shown in the drawing, is formed on the substrate 40 including inside of the through hole 49. This insulating film may be made out of SiO2, SiN and the like and is formed by sputtering, CVD or oxidization.

Then the seed layers 43, 47 to be seeds of the electroplated coating layers are formed inside of the through hole 46, 49 and at an adjoining area of the front surface 41 and the back surface 45 around the through hole 46, 49 on the insulating film by sputtering (Fig. 4C). At this point, because the through hole 46, 49 has not the shape whose center portion becomes concave as in the prior art technology, the seed layers 43, 47 can be formed easily inside of the through hole 46, 49 and around the opening of the through hole 46, 49 of the front surface 41 and the back surface 45 continuing from inside.

Next, the electroplated coating or the electroless-plated coating is performed on the through hole 46, 49 based on the seed layer 43, 47, and the conducting layer 44 made of Cu and the like is formed (Fig. 4D). As a result, the interposer which has the conducting layer without any generation of the void inside of the through hole 46, 49 can be formed utilizing simple manufacturing process.

Though the explanation is made about the case in which only one through hole 46, 49 is made in the above described embodiment, a plurality of through holes 46, 49 may be formed.

At this point, it is contemplated that the similar through hole having slopes inside may be formed by the wet etching. However by the wet etching, there may be a problem that a slope of the through hole becomes too broad to get a predetermined shape of the through hole. To the contrary, by the dry etching, the through hole with a predetermined shape can be formed because the manufacturing control of the slope of the through hole is easy.

### (5) Fifth Embodiment

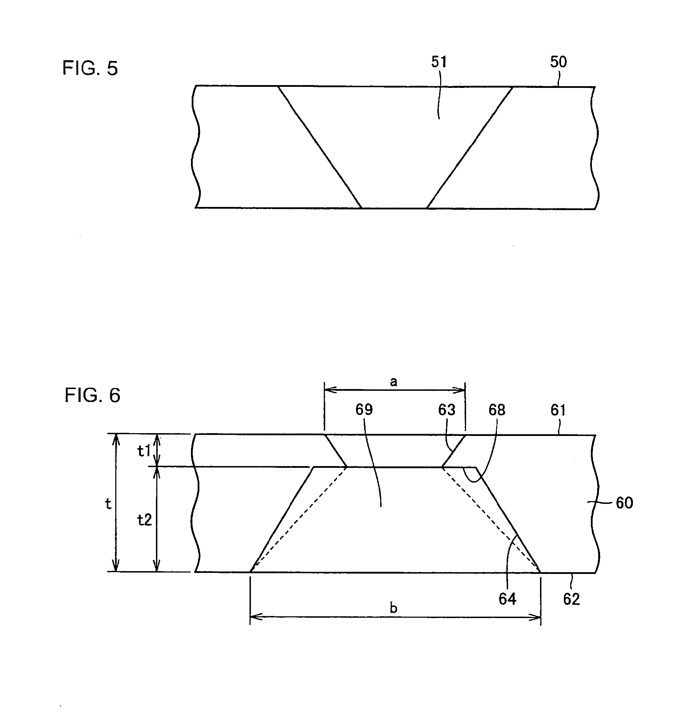

Next, an explanation will be given on the fifth embodiment of the present invention. Fig. 5 is a cross sectional view to show a through hole on the substrate of an interposer according to the fifth embodiment of the present invention corresponding to Fig. 4B of the fourth embodiment. In the fourth embodiment, the explanation is made in a case in which etching is performed from both sides of the silicon substrate 40. In this embodiment a through hole 51 whose diameter becomes smaller as it goes inside from only one surface of the front surface or the back surface of the substrate 50, is formed as shown in Fig. 5 by performing the etching only from the front surface of the silicon substrate 50. Further, the through hole 51 is made to be conductive by filling a conductive material inside of the through hole 51 by the same method as shown in Fig. 4A to Fig. 4D.

Even in this embodiment, the seed layer and the conductive layer based on the seed layer, can be formed easily as in the fourth embodiment, and the same effect can be obtained as the fourth embodiment.

### (6) Sixth Embodiment

Next, an explanation will be given on the further different embodiment of the present invention. Fig. 6 is a cross sectional view to show a through hole on the substrate 60 of an interposer according to the sixth embodiment of the present invention corresponding to Fig. 4B of the fourth embodiment.

In this embodiment, the holes 63, 64 are formed whose diameters become respectively smaller as they go inside from the front surface 61 and the back surface 62 on the substrate 60 similar to the fourth embodiment, however, the diameters of them are different at the front surface 61 and the back surface 62. In other words, referring to Fig. 6, the substrate 60 has a thickness "t", the hole on the front surface 61 has a diameter "a" and the hole on the back surface 62 has a diameter "b" where a < b. The hole 63 on the front surface 61 has a depth "t1" and the hole 64 on the back surface 62 has a depth "t2" to the inside of the hole. As a result, a step portion 68 is formed inside of the substrate 60. At this point, etching for different diameters may be performed from both of the front surface 61 and the back surface 62 similar to the fourth embodiment so as to form the front side hole 63 and the back side hole 64 with different diameters and to form the through hole 69 at any position whereby a structure without the step portion 68 may be formed as shown by the dotted line in the drawing. After manufacturing as described above, the inside of the through hole 69 is filled with the conducting layer.

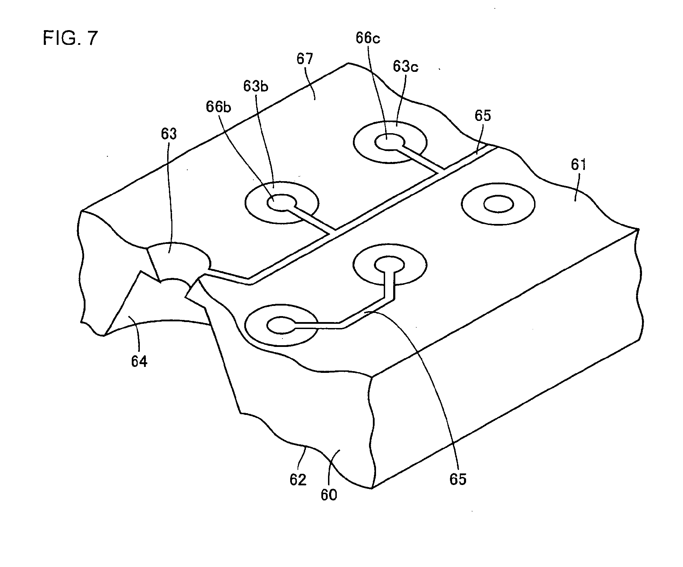

Fig. 7 is a perspective view to show the substrate 60 of the interposer which has the cross sectional structure shown in Fig. 6. Referring to Fig. 7 in this embodiment, because diameters of the through hole 69 are determined at the front surface 61 and the back surface 62 as described above, wiring area 67 can be made wider at the front surface 61 than at the back surface 62. By this arrangement, wiring rules for the front surface 61 and the back surface 62 can be independently settled, and wider degree of freedom for designing a wiring width and a wiring layout can be obtained on the front surface 61. Moreover, because size of the opening portion of the through hole 69 is designed larger at the back surface 62, process window for a through wiring can be expanded such that electroplating liquid penetrates well, the aspect ratio of the through hole becomes small, and the like.

At this point, the wiring 65 in Fig. 7 is performed via terminals 66b, 66c which are formed in the pads 63b, 63c formed on the surface of the conducting layer filled in the hole 63.

### (7) Seventh Embodiment

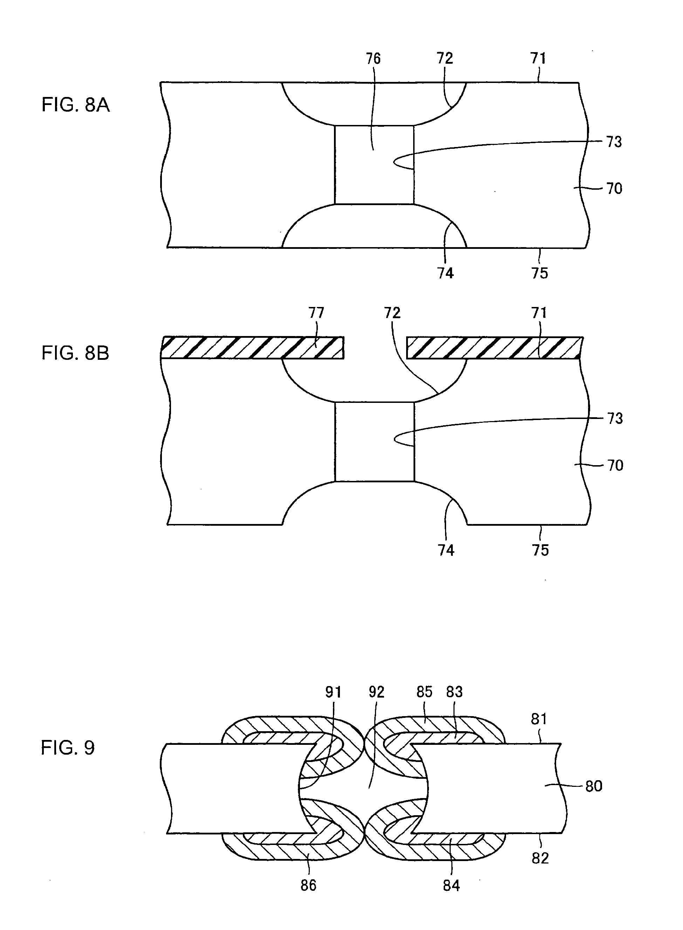

Next, an explanation will be given on the seventh embodiment of the present invention. Fig. 8A is a diagram to show a cross sectional structure of the substrate 70 in this embodiment of the present invention. Referring to Fig. 8A in this embodiment, the through hole 76 has semispherical opening portions 72, 74 on the front surface 71 and the back surface 75 of the substrate 70 and a cylindrical hole 73 is formed at the central portion of the through hole 76.

By forming the through hole 76 with the above described shape, penetration of the electroplating liquid is improved and improvement of adhesion of the electroplated coating can be expected. Further, suppression of peeling of the adhered electroplated coating can be expected.

Next, the conducting hole is completed by filling of the through hole 76 with the conductive material utilizing the electroplated coating and the like similar to the embodiments described above.

Next, explanation will be made how to manufacture the through hole 76 in this embodiment. Fig. 8B is a diagram to show a manufacturing process of the through hole 76 shown in Fig. 8A. Referring to Fig. 8B, a resist 77 is located on the surface 71 of the substrate 70, and the opening portion is formed on a predetermined position to perform isotropic etching. By this, the semispherical opening portion 72 is formed on the front surface 71 side. Similarly, the semispherical opening portion 74 on the back surface 75 side is also formed. Then, the anisotropic etching is performed to form the cylindrical hole 73.

At this point, forming of the cylindrical hole in this embodiment may be applied to the above described respective embodiments.

Though in the above described embodiments explanation is made on cases that circular or cylindrical through holes are utilized, the present invention should not be restricted to these embodiments, and a rectangular or a polygonal through hole may be used.

Though in the above described embodiments, explanation is made on cases that the conducting layers are formed utilizing the electroplated coating based on the seed layer, the present invention should not be restricted to these embodiments, and the conducting layer may be formed only by the seed layer.

Though in the above described embodiments, explanation is made on cases that filling of the conducting material into the through hole is performed by the electroplated coating, the present invention should not be restricted to these embodiments, and the filling may be performed by the electroless plating or the evaporation.

Though in the above described embodiments, explanation is made on cases that forming of the through hole is performed by utilizing the dry etching, the present invention should not be restricted to these embodiments, and the forming may be performed by utilizing the wet etching.

### INDUSTRIAL APPLICABILITY

The manufacturing method of the interposer in accordance with the present invention can be utilized advantageously as a manufacturing method of the interposer in which the void is not generated in the through hole because the conducting layer by the electroplated coating is surely formed at the through hole from one side of the substrate to another side.

## Claims

1. An interposer comprising:
a substrate which has one surface, another surface opposed to said one surface, and a through hole passing through from said one surface to said another surface;
a seed layer which is formed at an opening portion of said through hole on said one surface side of said substrate;
an electrode layer for electroplated coating which is formed by covering said seed layer; and
an electroplated coating layer which extends from said electrode layer for electroplated coating to said another surface side to fill said through hole.

2. The interposer according to claim 1, wherein said through hole has a shape whose center portion is concave.

3. The interposer according to claim 1, wherein said seed layer, said electrode layer for electroplated coating and said electroplated coating layer are made out of the same material.

4. The interposer according to claim 1, wherein at least two of said seed layer, said electrode layer for electroplated coating and said electroplated coating layer are made out of different materials.

5. A method for manufacturing an interposer comprising steps of:
preparing a substrate which has one surface and another surface opposed to said one surface;
forming a through hole on said substrate;
forming a seed layer at an opening portion of said through hole on said one surface side; and
filling said through hole by forming an electroplated coating layer from said seed layer on said one surface side to said another surface side.

6. The method for manufacturing an interposer according to claim 5, wherein said step of filling said through hole by forming an electroplated coating layer from said seed layer on said one surface side to said another surface side includes steps of:
forming an electrode layer for electroplated coating to close said through hole at said one surface side; and
forming said electroplated coating layer utilizing said electrode layer.

7. The method for manufacturing an interposer according to claim 5, wherein said step of forming the through hole includes a step of forming a through hole whose center portion becomes concave.

8. The method for manufacturing an interposer according to claim 6, wherein said seed layer, said electrode layer for electroplated coating and said electroplated coating layer are made out of the same material.

9. The method for manufacturing an interposer according to claim 6, wherein at least two of said seed layer, said electrode layer for electroplated coating and said electroplated coating layer are made out of different materials.

10. An interposer having a through hole wherein:
said through hole is made from a surface of one side of said substrate to a surface of another side;
said through hole has a first opening area at said surface of said one side and the opening area becomes smaller in succession as the hole goes from said surface to inside and has a second opening area at said surface of said another side and the opening area becomes smaller in succession as the hole goes from said surface of another side to inside; and
a conducting layer is formed on said through hole.

11. The interposer according to claim 10, wherein the first opening area and the second opening area are different.

12. The manufacturing method for the interposer according to claim 10, wherein said through hole has a cylindrical hole part having the same opening area between said surfaces of said one side and said another side.

13. An interposer having a through hole, wherein
said through hole is made from a surface of one side of said interposer to a surface of another side;
said through hole has a first opening area at said surface of said one side, and said first opening area becomes smaller in succession as the hole goes from said surface of said one side to said surface of said another side; and
a conducting layer is formed on said through hole.

14. A method for manufacturing an interposer comprising steps of:
preparing a substrate which has one surface and another surface opposed to the one surface;
forming a through hole by performing an etching such that an opening area of said through hole becomes smaller in succession as the hole goes from said surface of said one side and from said surface of said another side to inside; and
forming a conducting layer in said through hole.

15. The method for manufacturing an interposer according to claim 14, wherein said etching is performed such that said opening area of said surface on said one side and said opening area of said surface on said another side are different.

16. The method for manufacturing an interposer according to claim 14 further comprising a step of forming a through hole whose opening area at said surface of said one side is the same as that at said surface of said another side.

17. A method for manufacturing an interposer comprising steps of:
preparing a substrate which has one surface and another surface opposed to the one surface;
forming a through hole by performing an etching such that an opening area of said through hole becomes smaller in succession as the hole goes from said surface of said one side to said surface of said another side; and
forming a conducting layer in said through hole.

18. The method for manufacturing an interposer according to claim 14, wherein said etching is performed utilizing dry etching.

19. The method for manufacturing an interposer according to claim 14, wherein said step of forming said conducting layer is performed utilizing evaporation, electroplated coating or electroless plating.

## Amended claims

### Amended claims under Art. 19.1 PCT

**1.** An interposer comprising:
a substrate which has one surface, another surface opposed to said one surface, and a through hole passing through from said one surface to said another surface;
a seed layer which is formed at an opening portion of said through hole on said one surface side of said substrate;
an electrode layer for electroplated coating which is formed by covering said seed layer; and
an electroplated coating layer which extends from said electrode layer for electroplated coating to said another surface side to fill said through hole.

**2.** The interposer according to claim 1, wherein said through hole has a shape whose center portion is concave.

**3.** The interposer according to claim 1, wherein said seed layer, said electrode layer for electroplated coating and said electroplated coating layer are made out of the same material.

**4.** The interposer according to claim 1, wherein at least two of said seed layer, said electrode layer for electroplated coating and said electroplated coating layer are made out of different materials.

**5.** A method for manufacturing an interposer comprising steps of:
preparing a substrate which has one surface and another surface opposed to said one surface;
forming a through hole on said substrate;
forming a seed layer at an opening portion of said through hole on said one surface side; and
filling said through hole by forming an electroplated coating layer from said seed layer on said one surface side to said another surface side.

**6.** The method for manufacturing an interposer according to claim 5, wherein said step of filling said through hole by forming an electroplated coating layer from said seed layer on said one surface side to said another surface side includes steps of:
forming an electrode layer for electroplated coating to close said through hole at said one surface side; and
forming said electroplated coating layer utilizing said electrode layer.

**7.** The method for manufacturing an interposer according to claim 5, wherein said step of forming the through hole includes a step of forming a through hole whose center portion becomes concave.

**8.** The method for manufacturing an interposer according to claim 6, wherein said seed layer, said electrode layer for electroplated coating and said electroplated coating layer are made out of the same material.

**9.** The method for manufacturing an interposer according to claim 6, wherein at least two of said seed layer, said electrode layer for electroplated coating and said electroplated coating layer are made out of different materials.

**10.** An interposer having a through hole wherein:
said through hole is made from a surface of one side of said substrate to a surface of another side;
said through hole has a first opening area at said surface of said one side and the opening area becomes smaller in succession as the hole goes from said surface to inside and has a second opening area at said surface of said another side and the opening area becomes smaller in succession as the hole goes from said surface of another side to inside; and
a conducting layer is formed on said through hole.

**11.** The interposer according to claim 10, wherein the first opening area and the second opening area are different.

**12.** The manufacturing method for the interposer according to claim 10, wherein said through hole has a cylindrical hole part having the same opening area between said surfaces of said one side and said another side.

**13.** (amended) The interposer according to claim 1, wherein said through hole has a smaller opening area in succession as it goes from said surface of said one side to said surface of said another side.

**14.** A method for manufacturing an interposer comprising steps of:
preparing a substrate which has one surface and another surface opposed to the one surface;
forming a through hole by performing an etching such that an opening area of said through hole becomes smaller in succession as the hole goes from said surface of said one side and from said surface of said another side to inside; and
forming a conducting layer in said through hole.

**15.** The method for manufacturing an interposer according to claim 14, wherein said etching is performed such that said opening area of said surface on said one side and said opening area of said surface on said another side are different.

**16.** The method for manufacturing an interposer according to claim 14 further comprising a step of forming a through hole whose opening area at said surface of said one side is the same as that at said surface of said another side.

**17.** (amended) The method for manufacturing the interposer according to claim 5, wherein said step of forming said through hole on said substrate is performed utilizing etching such that an opening area of said through hole becomes smaller in succession as the hole goes from one side of the substrate to another side.

**18.** The method for manufacturing an interposer according to claim 14, wherein said etching is performed utilizing dry etching.

**19.** The method for manufacturing an interposer according to claim 14, wherein said step of forming said conducting layer is performed utilizing evaporation, electroplated coating or electroless plating.

Statement under Art. 19.1 PCT
Claim 13 is amended to be dependent on claim 1 and claim17 is amended to be dependent on claim 5.

Since claims 1 and 5 are regarded as having inventive step, claims 13 and 17 have inventive step as well.
